# EUROPÄISCHE PATENTSCHRIFT

(11) **EP 1 329 146 B1**
(45) Veröffentlichungstag und Bekanntmachung des Hinweises auf die Patenterteilung: **04.08.2004**
(21) Anmeldenummer: 01989043.3
(22) Anmeldetag: 17.10.2001
(51) Int. Cl.: H05K 7/20, H05K 5/00

(54) **KÜHLVORRICHTUNG**
COOLING DEVICE
DISPOSITIF DE REFROIDISSEMENT

(30) Priorität: 24.10.2000 DE 10052717
(43) Veröffentlichungstag der Anmeldung: 23.07.2003
(73) Patentinhaber: Siemens Aktiengesellschaft, 80333 München (DE)
(72) Erfinder: ALLWANG, Reinhard, 92421 Schwandorf (DE)
(86) Internationale Anmeldenummer: PCT/DE2001/003963
(87) Internationale Veröffentlichungsnummer: WO 2002/035899

(56) Entgegenhaltungen:
- EP-A- 0 014 249
- EP-A- 0 165 829
- EP-A- 0 309 986
- BAUMAN, PITTWOOD, WEISS: "Multimodule Heat Sink. January 1977." IBM TECHNICAL DISCLOSURE BULLETIN, Bd. 19, Nr. 8, 1. Januar 1977 (1977-01-01), Seiten 2976-2977, XP002191675 New York, US

## Beschreibung

Die Erfindung betrifft eine Kühlvorrichtung, insbesondere zur Kühlung von elektrischen und/oder elektronischen Komponenten und/oder Schaltungen gemäß den Merkmalen des unabhängigen Anspruches.

Es sind verschiedene Kühlvorrichtungen bekannt, mit denen elektrische oder elektronische Bauteile, insbesondere Halbleiterbauelemente und Prozessoren mit starker Wärmeentwicklung, gekühlt werden können. Primäres Ziel dabei ist es, die am Bauelement aus entstehender Verlustleistung resultierende Wärmeenergie an die Umgebung oder an ein Kühlmedium abzugeben. Passive Kühler, bspw. in Form von Metallrippen, haben eine begrenzte Kühlwirkung, insbesondere bei sehr gedrängtem und kompaktem Einbau des zu kühlenden Elementes, weil in diesem Fall nur eine begrenzte Luftzufuhr möglich ist. Aktive Kühler in Form von Ventilatoren können zwar aufgrund des schnelleren Luftaustausches insgesamt mehr Wärme abführen, haben aber aber die gleichen grundsätzlichen Beschränkungen wie passive Kühler; d.h. bei großen Temperaturen am zu kühlenden Bauelement sind auch sie nicht in der Lage, genug Luft auszutauschen.

Bekannt sind weiterhin Flüssigkeitskühler im Elektronikbereich, auf denen die verlustleistungsbehafteten Bauelemente aufgebracht werden können. Allerdings haben derartige handelsübliche Elektronikkühler einen relativ großen Platzbedarf und bedingen dadurch einen relativ großen Abstand der Bauelemente zueinander. Bei sehr kompakten Aufbauten, bspw. in Steuerschaltungen zum Einsatz in Kraftfahrzeugen ist ein derartiger erheblicher Platzbedarf sehr nachteilig, womit diese Art von Kühlern eher für Laboraufbauten geeignet sind als für den Großserieneinsatz im Kraftfahrzeugbereich.

Aus der Patentschrift EP-A-0 309 986 ist ein elektronisches Steuergerät zur Verwendung in einem Kraftfahrzeug bekannt, das eine gute thermische Leitfähigkeit aufweist, wobei eine Seite der Grundplatte des Steuergeräts mit dem Rotorküklwasser in Verbindung steht. Auf der anderen seite der Grundplatte sind keramische Leiterplalten angeordnet, auf denen Halbleiterbausteine befestigt sind.

Aus der Patentschrift DE 198 13 532 C1 ist ein Steuergerät mit Flüssigkeitskühlung bekannt, bei dem an einer Außenwand des Steuergeräts ein relativ großflächiger, von einer Flüssigkeit durchströmter Kühler angebracht ist. Die mechanische und thermische Koppelung zwischen Kühler und Steuergerät erfolgt mittels einer elastischen und wärmeleitenden Kontaktplatte. Nachteilig an dieser Anordnung ist der zusätzliche Bauaufwand für die nachträgliche Anbringung des Kühlers am Steuergerät sowie die ungleichmäßige Kühlwirkung für die Komponenten im Steuergerät, die an der Kontaktstelle des Kühlers am größten ist, jedoch an der Gehäuserückseite deutlich geringer ausfällt. Nicht zuletzt ist auch diese Bauausführung relativ voluminös und daher nicht für alle Anwendungsbereiche geeignet.

Es ist ein Ziel der Erfindung, eine Vorrichtung zur Kühlung eines Steuergerätes oder anderer elektrischer Komponenten und/oder Schaltungen bereitzustellen, die einen kompakten Aufbau und gleichzeitig eine möglichst effektive Abführung von Wärmeverlustleistung der Komponenten und/oder der Schaltungen ermöglicht.

Dieses Ziel der Erfindung wird mit einer Kühlvorrichtung erreicht, wie sie im unabhängigen Anspruch definiert ist. Vorzugsweise weist die Kühlvorrichtung, welche insbesondere zur Kühlung von elektrischen und/oder elektronischen Komponenten und/oder Schaltungen im Kraftfahrzeugbereich oder in anderen Bereichen eingesetzt werden kann, ein im wesentlichen flaches Metallgehäuse mit Flüssigkeitskühlung auf. Eine flache Unterseite dieses Gehäuses weist mehrere Auflageflächen zur thermisch leitenden Kontaktierung von Halbleiterelementen auf. Im Gehäuse ist ein Kühlkanal vorgesehen, der mit einem Volumenstrom von Kühlflüssigkeits durchspült werden kann. An einer Unterseite der Kühlvorrichtung neben den Auflageflächen für Halbleiterbauelemente ist eine Einbaumulde mit zumindest einer Einschnünung zur Umhüllung von passiven Bauelementen vorgesehen. Solche passive Bauelemente können bspw. Kondensatoren oder Spulen oder dergleichen sein.

In einer Variante der erfindungsgemäßen Kühlvorrichtung kann diese auch mehrere abschnittsweise parallel zueinander angeordnete Kühlkanäle aufweisen, die jeweils in Verbindung zueinander und in Verbindung mit den Anschlussstutzen zur Zuund Abfuhr von Kühlflüssigkeit stehen.

Das Gehäuse der Kühlvorrichtung besteht vorzugsweise aus Metallblech, kann jedoch auch aus spritzgegossenem Leichtmetall bestehen. Vorteilhaft ist eine Ausführung, bei der die Kühlvorrichtung aus mehreren dichtend übereinander geschichteten Blechscheiben besteht.

Lokale, durch Gaseinschlüsse verursachte Wärmemaxima am Kühlkanal können durch einen mit der Wand des Kühlkanals in Verbindung stehenden Bypass, der an die Unterseite (4) der Kühlvorrichtung (2) mündet, wirksam verhindert werden. Der Bypass kann auch als reduzierter Kühlquerschnitt ausgeführt, bzw. bezeichnet werden.

Die Kühlvorrichtung kann mit Hilfe von wenigstens zwei Distanzstücke an der Unterseite auf einer Leiterplatte montiert werden, wobei die Distanzstücke vorzugsweise, jedoch nicht unbedingt für die richtig beabstandete Montage der Kühlvorrichtung auf einer Leiterplatte sorgen. Zudem sorgen sie für eine Kühlung der Leiterplatte.

Besonders bevorzugt ist ein Einsatz der Kühlvorrichtung im Kraftfahrzeug. Die Kühlvorrichtung kann bspw. zur Aufnahme von Steuerungskomponenten eines integrierten Starter-Generators und/ oder einer elektrischen Getriebesteuerung, bspw. zur Spannungswandlung, in einem Kraftfahrzeug eingesetzt werden. Die im Gehäuse befindlichen Kühlkanäle können in diesem Fall wahlweise mit einem Kühlkreislauf einer Brennkraftmaschine gekoppelt sein.

Weitere vorteilhafte Ausbildungen der Erfindung sind in den abhängigen Ansprüchen gekennzeichnet.

Nachfolgend wird die Erfindung anhand von bevorzugten Ausführungsbeispielen unter Bezugnahme auf die Zeichnung näher erläutert. Es zeigen:
- Figur 1: eine perspektivische Ansicht auf die den zu kühlenden Bauelementen zugewandte Unterseite der erfindungsgemäßen Kühlvorrichtung,
- Figur 2: eine perspektivische Ansicht auf die Oberseite der erfindungsgemäßen Kühlvorrichtung und
- Figur 3: eine Draufsicht auf die Unterseite der Kühlvorrichtung entsprechend Figur 1.

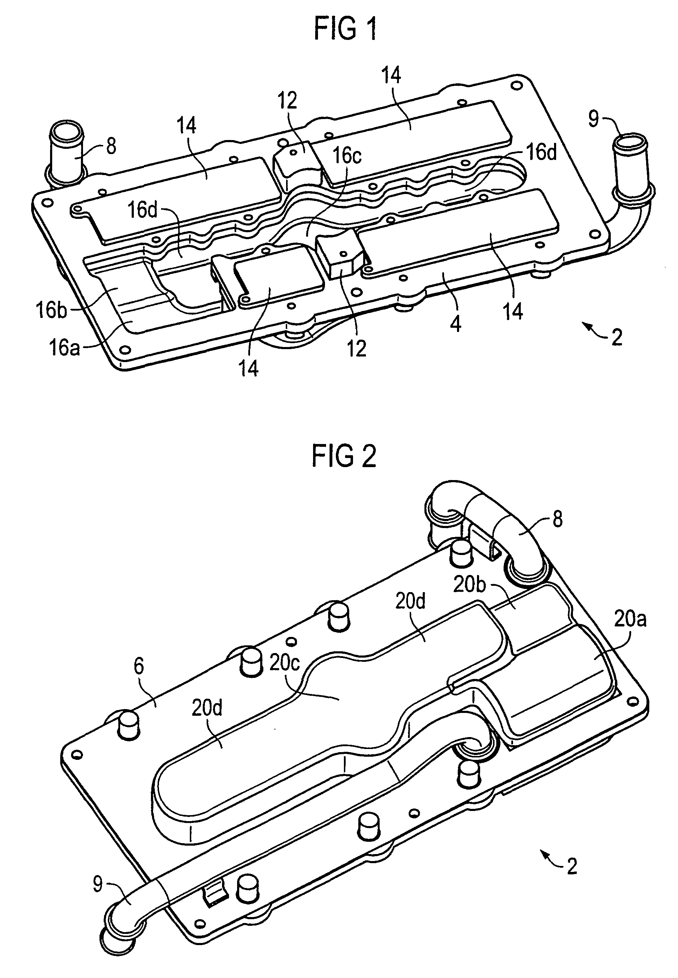

Die Figur 1 zeigt eine erfindungsgemäße Kühlvorrichtung 2 in einer perspektivischen Ansicht von unten, d.h. auf die den zu kühlenden Bauelementen zugewandte Unterseite 4. Die Kühlvorrichtung 2 weist im dargestellten Ausführungsbeispiel einen im wesentlichen rechteckigen Grundriss mit abgerundeten Ecken auf. Ebenso möglich sind jedoch fast beliebig andere Gehäuseformen sowie schräge oder abgerundete Ecken und Kanten. Erkennbar sind zwei über den Grundriss der Kühlvorrichtung 2 hinausragende Anschlussstutzen 8, 9, die einen Einlass sowie einen Auslass für die in der Kühlvorrichtung zirkulierende Kühlflüssigkeit bilden. Die Anschlussstutzen 8, 9 sind vorzugsweise in der Nähe einer schmalen Längsseite der Kühlvorrichtung 2 aus dieser herausgeführt, so dass der Kühlkanal annähernd U-förmig im Gehäuse der Kühlvorrichtung 2 verläuft.

Als Material für das Gehäuse der Kühlvorrichtung 2 eignet sich insbesondere Metallblech, bspw. Edelstahl, Aluminium, Magnesium oder entsprechende Legierungen. Aluminium weist eine besonders hohe Wärmeleitfähigkeit auf und ermöglicht daher einen guten Wärmeübergang von den mit den zu kühlenden Bauteilen in Berührung stehenden Flächen zu der zirkulierenden Kühlflüssigkeit. Ein solches Aluminium- oder Magnesiumgehäuse lässt sich auf einfachem Weg mittels Druck- oder Feingussverfahren herstellen, wobei sich die Kühlkanäle über sog. verlorene Kerne auf einfache Weise einbringen lassen. Ebenso möglich ist ein mehrschichtiger Aufbau der Kühlvorrichtung 2 aus übereinander geschichteten Blechen, wobei die Kühlkanäle im Inneren der Kühlvorrichtung 2 durch Erhebungen oder Ausprägungen in den Blechen entstehen, die dadurch an diesen Stellen nicht aneinander anliegen, sondern einen Hohlraum bilden. Die aufeinander geschichteten Bleche können bspw. durch Kleben, löten oder schweißen oder mittels konventioneller Dichtungen (z.B. O-Ring) dichtend miteinander verbunden sein. Auch ist eine bauliche Kombination aus Guss und Blech oder Guss und Kunststoff- und/oder Blechscheiben möglich.

Die aus der Kühlvorrichtung 2 herausgeführten Anschlussstutzen 8, 9 sind mit den Kühlkanälen im Inneren der Kühlvorrichtung verbunden und dienen zur Anbindung des Gehäuses an einen Kühlkreislauf. Als Kühlmittel kommt dabei insbesondere Wasser oder ein Gemisch aus Wasser und Glysantin in Frage, das von einer Pumpe umgewälzt wird. Ebenso möglich ist es jedoch auch, den Kühlkreislauf an den bereits vorhandenen Kühlkreislauf einer wassergekühlten Brennkraftmaschine eines Kraftfahrzeuges oder an vorhandene Klimageräte anzuschließen. Falls im oder am Gehäuse ein zusätzlicher Temperatursensor vorhanden ist, kann dessen Ausgangssignal zur Feinsteuerung des Kühlkreislaufes dienen, bspw. indem die Durchflussgeschwindigkeit und/oder der Volumenstrom der zu- und abgeführten Kühlflüssigkeit reguliert wird.

Wie besonders in Figur 1 erkennbar, sind auf der Unterseite 4 der scheibenartigen Kühlvorrichtung verschiedene Bereiche zur Kontaktierung mit verschiedenen elektronischen Bauelementen vorgesehen. So erstreckt sich zunächst eine konturierte Einbaumulde 16, bspw. für Kondensatoren und Spulen, mittig in der Unterseite 4 entlang der Längserstreckungsrichtung der Längsseiten der Kühlvorrichtung, wobei die Einbaumulde 16 einen Mindestabstand zu den schmaleren Seiten der Kühlvorrichtung 2 einhält. Die Einbaumulde 16 weist, ausgehende von der Unterseite 4, eine im wesentlichen senkrechte Begrenzung auf und wird in ihrer Tiefe von einer parallel zur Unterseite 4 verlaufenden Begrenzung abgeschlossen. Die Einbaumulde 16 weist mehrere Einschnürungen in der die Unterseite 4 durchbrechenden Kontur auf, um für verschiedene umschlossene Bauelemente einen möglichst weitgehenden Kontakt und damit einen möglichst guten Wärmeübergang zu ermöglichen. Ausgehend von ihrer Mitte schließen sich in beide Längserstreckungsrichtungen der Einbaumulde 16 jeweils mehrere Einschnürungen an, die wiederum jeweils von kleineren Einbaumulden 16d für kleinere zylindrische Kondensatoren oder dergl. abgelöst werden.

Weiterhin ist in Figur 1 die in der dargestellten Ansicht links liegende Seite der Einbaumulde 16, die gegenüber dieser etwas flacher ausgestaltet ist und sich in einen rechteckigen Raum vergrößert, der somit eine Einbaumulde 16a für eine Spule und eine Einbaumulde 16b für einen quaderförmigen Kondensator bildet. In dieser Ansicht nicht erkennbar ist allerdings die zum Rand hin flacher werdenden Einbaumulde 16a für die Spule, die somit einer flach liegenden zylindrischen Spule angepasst ist.

Auf der die Einbaumulde 16 umgebenden flachen Unterseite 4 der Kühlvorrichtung 2 sind weiterhin vier leicht erhabene, flache Auflageflächen 14 erkennbar, die an besonders wärmebelasteten Bauelementen, wie bspw. Transistoren oder integrierten Schaltkreisen, anliegen. Vorzugsweise verläuft der U-förmige Kühlkanal direkt unter diesen Auflageflächen 14, so dass die maximale Kühlung über einen guten Kontakt der zu kühlenden Bauelemente zu diesen Auflageflächen 14 ermöglicht ist. Drei der vier Auflageflächen 14 sind in der gezeigten Ausführungsform als flache längliche Scheiben ausgestaltet, um eine große Anlagefläche für zu kühlende Bauelemente zu erhalten. Die vierte Auflagefläche 14 ist wegen ihrer Angrenzung an die Einbaumulde 16a für die Spule kürzer ausgeführt und besitzt daher einen annähernd quadratischen Grundriss.

Schließlich sind in der gezeigten Ausführungsform zwei Distanzstücke 12 erkennbar, die eine Auflagefläche für eine Leiterplatte oder dergl. bilden. Diese Distanzstücke 12 sind jeweils mittig zwischen der zentralen Einbaumulde 16c in nähe der beiden Längsseiten der Kühlvorrichtung 2 an deren flachen Unterseite 4 montiert und dienen vorzugsweise der Kühlung der Leiterplatte.

Figur 2 zeigt eine perspektivische Ansicht auf die Oberseite 6 der erfindungsgemäßen Kühlvorrichtung 2 entsprechend Figur 1. In dieser Ansicht ist besonders die mittig aus der flachen Oberseite 6 herausragende Einbaumulde, hier als Hutze 20 bezeichnet. Die Hutze 20 weist senkrecht aus der Oberseite 6 ragende Seitenwände sowie einen im wesentlichen flachen Abschluss auf, der somit parallel zur Oberseite 6 verläuft. Die Hutze 20 kann bspw. mittels Tiefziehprozess hergestellt sein und verläuft damit naturgemäß in den gleichen Konturen wie die zuvor beschriebene Einbaumulde 16, welche die Innenseite der Hutze 20 darstellt. Mittig ist die Hutze 20 relativ breit ausgeführt, um zwei aufrecht stehende zylindrische Kondensatoren aufnehmen zu können (20c), zu den Seiten hin wird die Hutze schmaler (20d), besitzt jedoch keine Einschnürungen wie die zuvor beschriebene Einbaumulde 16. Zu einer Seite hin ist die Hutze flacher ausgestaltet (20a, 20b) und folgt den Konturen einer flach auf einer Leiterplatte montierten Spule (20a) und eines quaderförmigen Kondensators (20b).

Die rohrförmigen Anschlussstutzen 8, 9 ragen zunächst senkrecht aus der Oberseite 6, um dann jeweils einen U-förmigen Bogen zu beschreiben, so dass ihre Öffnungen jeweils in Richtung zur Unterseite 4 der Kühlvorrichtung 2 weisen.

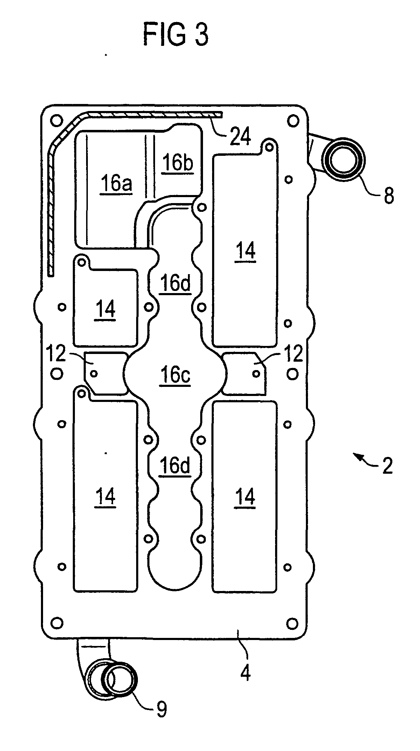

Figur 3 zeigt schließlich eine senkrechte Draufsicht auf die Unterseite 4 der erfindungsgemäßen Kühlvorrichtung 2 entsprechend Figur 1. Neben den zuvor bereits beschriebenen Distanzstücken 12, den Auflageflächen 14, der in vier Bereichen 16a, 16b, 16c, 16d unterteilte Einbaumulde 16 sowie den beiden über die Kontur der Kühlvorrichtung 2 hinaus ragenden Anschlussstutzen 8 und 9, von denen in dieser Ansicht jeweils der Rohreinlass bzw. -auslass erkennbar ist, ist ein schmaler Bypass 24 zur Entlüftung des Kühlkanals erkennbar. Dieser Bypass 24 erstreckt sich entlang zweiter angrenzender Randseiten der Unterseite 4, verläuft somit entlang einer Kante der Kühlvorrichtung und macht wie diese einen 90°-Bogen. Dieser Bypass 24 steht in Verbindung zur inneren Umhüllung des Kühlkanals und ermöglicht eine Entlüftung, was lokale Maxima im Kühlflüssigkeitsquerschnitt unproblematisch macht.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

## Patentansprüche

1. Kühlvorrichtung, insbesondere zur Kühlung von elektrischen und/oder elektronischen Komponenten und/oder Schaltungen, mit einem im wesentlichen flachen Metallgehäuse mit Flüssigkeitskühlung, das mehrere Auflageflächen (14) zur thermisch leitenden Kontaktierung von Halbleiterelementen aufweist, wobei im Gehäuse ein Kühlkanal verläuft, der mit einem Volumenstrom von Kühlflüssigkeit durchspült werden kann, wobei an einer Unterseite (4) der Kühlvorrichtung (2) neben den Auflageflächen (14) eine Einbaumulde (16) zur Umhüllung von passiven Bauelementen vorgesehen ist, und die Einbaumulde (16) zumindest eine Einschnürung aufweist.

2. Kühlvorrichtung nach Anspruch 1, wobei der in der Kühlvorrichtung verlaufende Kühlkanal mittels wenigstens zweier mit dem Kühlkanal in Verbindung stehende Anschlussstutzen (8, 9) mit einem Volumenstrom von Kühlflüssigkeits beaufschlagbar ist.

3. Kühlvorrichtung nach einem der vorstehenden Ansprüche, **gekennzeichnet durch** mehrere abschnittsweise parallel zueinander angeordnete Kühlkanäle im Inneren der Kühlvorrichtung (2).

4. Kühlvorrichtung nach einem der vorstehenden Ansprüche, **dadurch gekennzeichnet, dass** die Kühlvorrichtung (2) aus gegossenem Leichtmetall besteht.

5. Kühlvorrichtung nach einem der vorstehenden Ansprüche, **dadurch gekennzeichnet, dass** die Kühlvorrichtung (2) aus einer Kombination aus Guss und Blech oder Guss und Kunststoff- und/ oder Blechscheiben besteht.

6. Kühlvorrichtung nach einem der vorstehenden Ansprüche, **dadurch gekennzeichnet, dass** die Kühlvorrichtung (2) aus mehreren dichtend übereinander geschichteten Blechscheiben besteht.

7. Kühlvorrichtung nach einem der vorstehenden Ansprüche, **gekennzeichnet durch** einen mit beiden Kühlkanälen in Verbindung stehenden Bypass (24).

8. Kühlvorrichtung nach einem der vorstehenden Ansprüche, **gekennzeichnet durch** wenigstens zwei Distanzstücke (12) zur beabstandeten Montage der Kühlvorrichtung (2) auf einer Leiterplatte.

9. Kühlvorrichtung nach einem der vorstehenden Ansprüche, **dadurch gekennzeichnet, dass** die Kühlvorrichtung (2) zur Aufnahme von Steuerungskomponenten eines integrierten Starter-Generators und/ oder einer elektrischen Getriebesteuerung, bspw. zur Spannungswandlung, in einem Kraftfahrzeug vorgesehen ist, und dass die im Gehäuse befindlichen Kühlkanäle mit einem Kühlkreislauf einer Brennkraftmaschine gekoppelt sind.

## Claims

1. A cooling device, in particular for cooling electrical and/or electronic components and/or circuits, which has an essentially flat, liquid-cooled metal case having a plurality of supporting surfaces (14) for contacting semiconductor components on a thermally conducting basis, wherein a cooling channel capable of being flushed with a volumetric flow of liquid coolant is routed in the case, wherein a fitted cavity (16) for encasing passive components is provided alongside the supporting surfaces (14) on an underside (4) of said cooling device (2), and said fitted cavity (16) has at least one constriction.

2. The cooling device according to Claim 1, wherein a volumetric flow of liquid coolant can be applied by means of at least two couplings (8, 9) connected to the cooling channel to the cooling channel routed in the cooling device.

3. The cooling device according to one of the preceding Claims, **characterised by** a plurality of cooling channels arranged in the interior of the cooling device (2) mutually parallel section-by-section.

4. The cooling device according to one of the preceding Claims, **characterised in that** the cooling device (2) is made of cast light metal.

5. The cooling device according to one of the preceding Claims, **characterised in that** the cooling device (2) consists of a combination of cast and sheet-metal or cast and plastic and/or sheet-metal plates.

6. The cooling device according to one of the preceding Claims, **characterised in that** the cooling device (2) consists of a plurality of sheet-metal plates layered tightly one above the other.

7. The cooling device according to one of the preceding Claims, **characterised by** a bypass (24) connected to both cooling channels.

8. The cooling device according to one of the preceding Claims, **characterised by** at least two spacers (12) providing spaced mounting of the cooling device (2) on a printed-circuit board.

9. The cooling device according to one of the preceding Claims, **characterised in that** the cooling device (2) is provided in a motorised vehicle for accommodating control components of an integrated starter-generator and/or of an electrical transmission control, for voltage conversion for example, and that the cooling channels located in the case are coupled to a cooling circuit of an internal combustion engine.

## Revendications

1. Dispositif de refroidissement, en particulier pour refroidir des composants électriques et/ou électroniques et/ou des circuits électriques, comportant un boîtier métallique essentiellement plat qui est refroidi par un liquide et comprenant plusieurs surfaces d'appui (14) pour établir un contact thermique avec des éléments semiconducteurs, le boîtier renfermant un canal de refroidissement qui peut être parcouru par un courant volumique de liquide de refroidissement, un évidement de montage (16) pour envelopper des composants passifs étant prévu sur un côté inférieur (4) du dispositif de refroidissement (2) à côté des surfaces d'appui (14), cet évidement de montage (16) comportant au moins un rétrécissement.

2. Dispositif selon la revendication 1, dans lequel le canal de refroidissement passant dans le dispositif peut être chargé d'un courant de liquide de refroidissement au moyen d'au moins deux raccords (8, 9) qui communiquent avec le canal de refroidissement.

3. Dispositif de refroidissement selon l'une des revendications précédentes, **caractérisé par** plusieurs canaux de refroidissement disposés en parallèle par sections à l'intérieur du dispositif de refroidissement (2).

4. Dispositif de refroidissement selon l'une des revendications précédentes, **caractérisé en ce que** le dispositif de refroidissement (2) est constitué par un métal léger coulé.

5. Dispositif de refroidissement selon l'une des revendications précédentes, **caractérisé en ce que** le dispositif de refroidissement (2) est constitué par une combinaison de fonte et de tôle ou de fonte et de matière plastique et/ou de disques en tôle.

6. Dispositif de refroidissement selon l'une des revendications précédentes, **caractérisé en ce que** le dispositif de refroidissement (2) consiste en plusieurs disques en tôle empilés les uns sur les autres de manière étanche.

7. Dispositif de refroidissement selon l'une des revendications précédentes, **caractérisé par** une dérivation (24) en communication avec les deux canaux de refroidissement.

8. Dispositif de refroidissement selon l'une des revendications précédentes, **caractérisé par** au moins deux pièces d'écartement (12) pour un montage à distance du dispositif de refroidissement (2) sur une plaquette de circuit imprimé.

9. Dispositif de refroidissement selon l'une des revendications précédentes, **caractérisé en ce que** le dispositif de refroidissement (2) est prévu pour recevoir des composants de commande d'un démarreur-générateur intégré et/ou d'une commande électrique de boîte de vitesses, par exemple pour convertir la tension, dans un véhicule à moteur, et que les canaux de refroidissement se trouvant dans le boîtier sont couplés avec un circuit de refroidissement d'un moteur à combustion interne.
